# EUROPEAN PATENT APPLICATION

(11) **EP 1 998 419 A1**
(43) Date of publication of application: **03.12.2008**
(21) Application number: 07736924.7
(22) Date of filing: 20.03.2007
(51) Int. Cl.: H01S 5/18, G02B 27/28, G11B 7/125

(54) **TWO-DIMENSIONAL PHOTONIC CRYSTAL SURFACE LIGHT EMITTING LASER**

(30) Priority: 20.03.2006 JP 2006077469
(71) Applicant: Rohm Co., Ltd., Kyoto-shi, Kyoto 615-8585 (JP)
(72) Inventor: NODA, Susumu, Kyoto-shi, Kyoto 615-8510 (JP); MIYAI, Eiji, Kyoto-shi, Kyoto 615-8510 (JP); SAKAI, Kyosuke, Kyoto-shi, Kyoto 615-8510 (JP); OHNISHI, Dai, Kyoto-shi, Kyoto 615-8585 (JP); KUNISHI, Wataru, Kyoto-shi, Kyoto 615-8585 (JP)
(74) Representative: Hoeger, Stellrecht & Partner Patentanwälte
(86) International application number: PCT/JP2007/000267
(87) International publication number: WO 2007/108218

(57) **Abstract**

An objective of the present invention is to provide a laser capable of producing a radially polarized laser beam with an annular cross section. A laser oscillator 60 including an active layer 53 and two-dimensional photonic crystal 55 with circular holes 552 arranged in a square lattice pattern is provided between two electrodes 571 and 572. A first polarization control layer 581, which functions as a half-wave plate, and a second polarization control layer 582, which functions as a half-wave plate with a fast axis 592 extending at an angle of 45° to that of the first polarization control layer 581, are located on the laser oscillator 60. When a voltage is applied between the electrodes, a circumferentially polarized annular laser beam is emitted from the laser oscillator 60. When passing through the first polarization control layer 581 and the second polarization control layer 582, the laser beam is converted to a radially polarized beam. The resultant laser beam can be converged by a focusing lens to achieve a diameter smaller than the diffraction limit. Such a narrow beam is suitable for an optical pickup or many other devices.

## Description

### TECHNICAL FIELD

The present invention relates to a two-dimensional photonic crystal surface emitting laser that is usable in an optical pickup using a spot beam whose size is equal to or smaller than the diffraction limit, a laser-processing apparatus with high energy efficiency or similar devices.

### BACKGROUND ART

In the field of optical recording devices using a laser beam for recording (writing) information into a record medium and reproducing (or reading) the information from the record medium, reduction of the spot size of the laser beam has been demanded to increase the recording density in the record medium. However, simply converging the laser beam with a focusing lens cannot produce a laser beam with a spot size equal to or smaller than the diffraction limit determined by the wavelength of the laser beam and the numerical aperture of the focusing lens. Accordingly, in recent years, a technique for achieving a spot size smaller the diffraction limit has been studied. This technique is called the "super-resolution" technique.

Non-Patent Document I discloses a laser beam suitable for achieving a smaller spot size. Fig. 1 schematically shows a cross section of the laser beam. The gray area 11 in this figure indicates the region where the light is present, and the thick arrows indicate the polarizing direction. This laser beam has an annular cross section with no strength present at the central area 12 and is polarized from the center outwards (i.e. in the radial direction).. Such a laser beam is hereinafter called the "radially polarized annular laser beam." Converging the radially polarized annular laser beam can result in a laser beam having a beam diameter smaller than the diffraction limit.

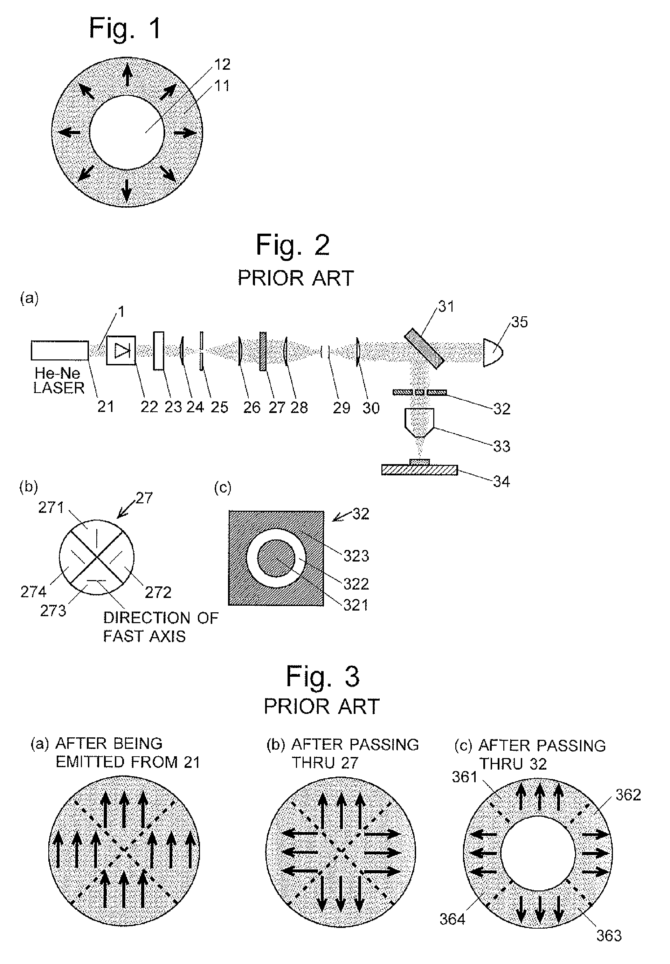

Non-Patent Document 2 discloses a method and device for producing a radially polarized annular laser beam. Fig. 2 shows the construction of the device. This device has the following components arranged in this order: a He-Ne laser 21, photodiode 22, half-wave plate 23, first focusing lens 24, pinhole 25, first collimator lens 26, polarization-converting plate 27, second focusing lens 28, non-confocal Fabry-Perot interferometer 29, second collimator lens 30, half mirror 31, aperture 32, objective lens 33 and sample stage 34. Located behind the half mirror 31 is a monitor diode 35 for detecting the light that has passed through the half mirror 31. The photodiode 22 and half-wave plate 23 both prevent retrogression of the laser beam generated by the He-Ne laser 21. The first focusing lens 24 and pinhole 25 are intended to give the laser beam a desired sectional shape. The first collimator lens 26 and second collimator lens 30 each produce a parallel beam from a non-parallel beam coming from the first focusing lens 24 or second focusing lens 28, and deliver the parallel beam onto the polarization-converting plate 27 or aperture 32. The configurations of the polarizing/conversing plate 27 (Fig. 2(b)) and aperture 32 (Fig. 2(c)) will be later described.

In this device, the He-Ne laser 21 generates a linearly polarized laser beam 1 (Fig. 3(a)). The laser beam 1 passes through the photodiode 22 and other components, and reaches the polarizing/converting plate 27. As shown in Fig 2(b), the polarizing/converting plate 27 has four sections 271 to 274 divided in units of 90° and arranged in a clockwise direction. Each section consists of a half-wave plate whose fast axis is differently oriented. Specifically, the direction of the fast axis in the sector 271 is the same as that of the linear polarization of the incident laser beam (fig. 3(a)), whereas the fast axes in the other three sectors 272, 273 and 274 are at angles of -45°, 90° and +45° from the aforementioned linear polarization, respectively. Due to the action of the half-wave plate, the polarization in each sector changes to an axially symmetrical direction with respect to the fast axis of that sector. As a result, in any of the sectors 271 to 274, the laser beam is polarized basically in the radial direction (Fig. 3(b)).
The laser beam that has passed through the polarization-converting plate 27 travels through the second focusing lens 28 and other components and reaches the half mirror 31, which reflects a portion of the laser beam toward the aperture 32. The aperture 32 has an annular transparent area 322, which allows the passage of light, and the blocking areas 321 and 323, which block the laser beam outside the transparent area 322. When the laser beam passes through the aperture 32, the beam's cross section becomes annular (Fig. 3(c)). After passing through the aperture 32, the laser beam is condensed by the objective lens 33. As stated earlier, the laser beam is polarized basically in the radial direction and has an annular cross section. Therefore, due to the super-resolution effect, it is possible to produce a narrow laser beam whose spot size is equal to or smaller than the diffraction limit, as described in Non-Patent Document 1.

A radially polarized laser beam can be suitably used in the field of metal-working using a laser beam as well as in the super-resolution technique. Non-Patent Document 3 discloses the result of a calculation, which proves that irradiating a metal with a radially polarized laser beam makes the processing rate higher than in the case of using a circularly or linearly polarized laser beam of the same energy level. According to that document, this is because metals have higher energy-absorbing efficiencies for radially polarized light than other kinds of polarized light.

Non-Patent Document 1: S. Quabis et al., "Focusing light to a tighter spot", Optics Communications, vol. 179, pp.1-7
Non-Patent Document 2: R. Dorn et al. "Sharper Focus for a Radially Polarized Light Beam", Physical Review Letters, vol. 91, No. 23, pp. 233901-1-233901-4
Non-Patent Document 3: V.G. Niziev et al., "Influence of beam polarization on laser cutting efficiency", Journal of Physics D-Applied Physics, vol. 32, No. 13, pp. 1455-1461

### DISCLOSURE OF THE INVENTION

### PROBLEMS TO BE SOLVED BY THE INVENTION

However, in the device disclosed in Non-Patent Document 2, the four sectors 271 to 274 of the polarization-converting plate 27 are designed to change the polarizing direction of the laser beam to a common direction within each of the four segments 361 to 364 of the beam's cross section (Fig. 3(c)) corresponding to the four sectors 271 to 274. According to this design, the polarizing direction at a position closer to one of the boundaries of the segments 361 to 364 will be more deviated from the radial direction. Therefore, in a strict sense, this laser beam is not radially polarized. The spot size of this laser beam is larger than that of an ideal laser beam which is radially polarized at any point.

Furthermore, the device disclosed in Non-Patent Document 2 uses a complex optical system including a large number of optical components to produce a radially polarized beam from a linearly polarized beam generated by the laser light source. Accordingly, this device is expensive.

Thus, an objective of the present invention is to provide a two-dimensional photonic crystal surface emitting laser that can generate a radially polarized laser beam having an annular cross section (i.e. a radially polarized annular laser beam) without using a complex optical system and thus reduce the cost.

### MEANS FOR SOLVING THE PROBLEMS

To solve the aforementioned problems, a two-dimensional photonic crystal surface emitting laser according to the present invention includes:
a) a laser oscillator including an active layer, a two-dimensional photonic crystal located on one side of the active layer, and a pair of electrodes between which the active layer and the two-dimensional photonic crystal are sandwiched, the laser oscillator emitting a circumferentially polarized laser beam with an annular cross section from the two-dimensional photonic crystal when a voltage is applied between the electrodes;
b) a first polarization control element, which is located on an optical path of the laser beam generated by the laser oscillator and functions as a half-wave plate; and
c) a second polarization control element, which is located on the optical path of the laser beam and functions as a half-wave plate, with a fast axis extending at an angle of 45° to that of the first polarization control element.

The first and second polarization control elements may preferably be layered on the active layer and the laser oscillator.

### EFFECT OF THE INVENTION

The two-dimensional photonic crystal surface emitting laser according to the present invention can produce a radially polarized annular laser beam in which light is radially polarized at any point. Condensing this laser beam can result in a laser beam with a spot size smaller than the diffraction limit. Since the radial polarization is truly realized at any point within the laser beam, the spot size of the laser beam in the present invention can be smaller than that achieved by the device disclosed in Non-Patent Document 2.

The first and second polarization control elements may be layered on the structure including the active layer, two-dimensional photonic crystal and two electrodes. This design enables the radially polarized laser beam to be produced using only a single piece of two-dimensional photonic crystal surface emitting laser device. Therefore, it is unnecessary to use complex optical systems for converting the type of polarization, so that the cost can be reduced.

A device for generating a super-resolution laser beam having a diameter equal to or smaller than the diffraction limit can be obtained by combining the two-dimensional photonic crystal surface emitting laser according to the present invention with a focusing lens for converging the laser beam generated by the two-dimensional photonic crystal surface emitting laser to a diameter equal to or smaller than the diffraction limit. Using this super-resolution laser beam generator as a light source in an optical pickup makes it possible to record information into an optical record medium with high density and reproduce information recorded in a high-density optical record medium.

The two-dimensional photonic crystal surface emitting laser according to the present invention may be used as a light source for irradiating a metallic workpiece with light in a laser-processing apparatus. Since the light generated by the present laser is radially polarized, the energy of the laser beam can be efficiently supplied to the metal, so that the metal can be quickly processed (e.g. cut or incused). It should be noted that this laser-processing apparatus does not require the laser beam to be converged to a diameter equal to or smaller than the diffraction limit.

### BRIEF DESCRIPTION OF THE DRAWINGS

Fig. 1 is a sectional view showing a cross section of an annular laser beam being polarized in a radial direction.
Fig. 2 is a schematic diagram showing an example of a conventional device for generating a radially polarized annular laser beam.
Figs. 3(a) and 3(b) are cross-sectional views each showing the state of polarization of a laser beam passing through the device shown in Fig. 2, and Fig. 3(c) is a cross-sectional view showing the state of polarization of a laser beam ultimately produced by the same device.
Figs. 4(a) and 4(b) are diagrams each showing the cross-sectional shape and state of polarization of a laser beam in the two-dimensional photonic crystal surface emitting laser according to the present invention, and Fig. 4(c) is a diagram showing the cross-sectional shape and state of polarization of the ultimately produced laser beam.
Fig. 5 is a perspective view showing an embodiment of the two-dimensional photonic crystal surface emitting laser according to the present invention.
Fig. 6 is a perspective view showing the structure of the two-dimensional photonic crystal 55 in the surface emitting laser of the present embodiment.
Figs. 7(a) and 7(b) are graphics showing a calculated result of the electromagnetic distribution within the two-dimensional photonic crystal 55 in the surface emitting laser of the present embodiment.
Fig. 8 shows a calculated result of the light strength and polarizing direction at a cross section of a laser beam emitted from the substrate 51 and entering the first polarization control layer 581 in the surface emitting laser of the present embodiment.
Fig. 9 is a set of photographs showing cross-sectional shapes of laser beams generated by the surface emitting lasers of the present embodiment and comparative example, and another set of photographs showing the polarizing direction of the same laser beams.
Fig. 10 is a perspective view showing another example of the two-dimensional photonic crystal for the surface emitting laser according to the present invention.
Figs. 11(a) and 11(b) are graphics showing a calculated result of the electromagnetic distribution within the crystal in the case where the two-dimensional photonic crystal 55' shown in Fig. 10 is used.

### EXPLANATION OF NUMERALS

1 ... Laser beam
11, 41 ... Area where light is present
12, 42 ... Central area of laser beam (where no light is present)
21 ... He-Ne laser
22 ... Photodiode
23 ... Half-wave plate
24 ... First focusing lens
25 ... Pinhole
26 ... First collimator lens
27 ... Polarization-converting plate
271, 272, 273, 274 ... Areas with fast axes differently oriented
28 ... Second focusing lens
29 ... Non-confocal Fabry-Perot interferometer
30 ... Second collimator lens
31 ... Half mirror
32 ... Aperture
32 ... Blocking area
322 ... Transparent area
33 ... Objective lens
34 ... Sample stage
35 ... Monitor diode
361, 362, 363, 364 ... Segments of cross section of laser beam, with light being polarized in a different direction at each segment
42 ... Center of cross section of laser beam
43 ... Radial direction at cross section of laser beam
441, 442, 443, 621, 622 ... Arrows indicating polarizing directions
451,452, 591,592... Fast axis
50 ... Surface emitting laser
51 ... Substrate
521, 522 ... Cladding layers
53 ... Active layer
54 ... Carrier-blocking layer
55 ... Two-dimensional photonic crystal
551 ... Body material
552 ... Hole
56 ... Contact layer
571 ...Lower electrode
572 ... Upper electrode
5721 .... Window of upper electrode
581 ... First polarization control layer
582 ... Second polarization control layer
60 ... Laser oscillator
611,612 ... Direction of polarizing filter
6311, 6312, 6321, 6322 ... Areas where light has passed through the polarizing filter

### BEST MODE FOR CARRYING OUT THE INVENTION

In the two-dimensional photonic crystal surface emitting laser according to the present invention (which is hereinafter simply called the "surface emitting laser"), a two-dimensional photonic crystal is provided on one side of the active layer, and a pair of electrodes are provided so that the active layer and two-dimensional photonic crystal are sandwiched between them. A spacer or similar member may also be provided between the active layer, the two-dimensional photonic crystal and the electrodes.

For the active layer, the one that has been used in conventional Fabry-Perot laser light sources is available. The two-dimensional photonic crystal in the present invention consists of a plate-shaped body material with a periodic arrangement of modified refractive index areas, i.e. the areas whose refractive index differs from that of the body material. The modified refractive index areas should preferably consist of holes since this structure provides a large difference in the refractive index between the body and the modified refractive index area and yet is easy to manufacture. However, it is also possible to create the modified refractive index areas by embedding appropriate members into the body. For example, in the case where the two-dimensional photonic crystal needs to be fused to another layer at a high temperature, the modified refractive index area consisting of an embedded member can be suitably used to prevent the high temperature from deforming the modified refractive index area. The modified refractive index area consisting of an embedded member can also be suitably used if the manufacturing process includes creating the two-dimensional photonic crystal and then epitaxially growing another layer.

The components described thus far (i.e. the active layer, the two-dimensional photonic crystal and the electrodes) constitute a laser oscillator. In this laser oscillator (with no polarization control element), when a voltage is applied between the electrodes, a laser beam is emitted in the direction perpendicular to the two-dimensional photonic crystal. According to the present invention, the laser oscillator is modified so that it will generate a laser beam that has an annular cross section (i.e. the light has no strength at around the center and finite strengths at positions apart from the center) and is polarized in a direction revolving around the center (i.e. in the circumferential direction). This beam is called the "circumferentially directed annular laser beam" in this specification.

To produce a circumferentially directed annular laser beam, it is possible to use a two-dimensional photonic crystal whose structure has a rotational symmetry with respect to an axis perpendicular to the crystal surface. A specific example is a two-dimensional photonic crystal in which circular modified refractive index areas are arranged in a square or triangular lattice pattern. If the center of the modified refractive index area is defined as a lattice point, an oscillation mode of such a two-dimensional photonic crystal creates a standing wave within the two-dimensional photonic crystal, with the electric field vector being anti-symmetrical with respect to all the axes connecting the nearest lattice points and the axes connecting the second-nearest lattice points. At around the center of the two-dimensional photonic crystal, the overlap integral of the standing wave and an external plane wave is zero, whereas the overlap integral of the two waves at positions apart from the center is not zero but has finite values since the extent of the two-dimensional photonic crystal is limited. As a result, the laser beam thereby produced has an annular cross section. The oscillation mode of the two-dimensional photonic crystal is generally created so that the electric field encircles each modified refractive index area, and this electric field is amplified by the aforementioned two-dimensional photonic crystal with a rotational symmetry. As a result, a circumferentially polarized laser beam is generated.

A first polarization control element, which functions as a half-wave plate, and a second polarization control element, which also functions as a half-wave plate and has a fast axis extending at an angle of 45° to that of the first polarization control element, are provided on the optical path of the laser beam generated by the laser oscillator. The phrase "functions as a half-wave plate" means that the element can convert the polarizing direction of light passing through it to an axially symmetrical direction with respect to a specific axis (fast axis). Although one or both of the two polarization control elements may be provided separately from the laser oscillator, it is preferable to layer them on the laser oscillator to form an integral unit since this design enables the device to be handled as a single surface emitting laser element.

An operation of the surface emitting laser according to the present invention is hereinafter described. When a voltage is applied between the electrodes, a current is injected into the active layer and light is emitted from this layer. This light forms a standing wave within the two-dimensional photonic crystal and is thereby amplified. As a result, a laser beam is emitted in the direction perpendicular to the surface of the two-dimensional photonic crystal. This laser beam passes through the first and second polarization control elements in this order and is ultimately extracted to the outside.

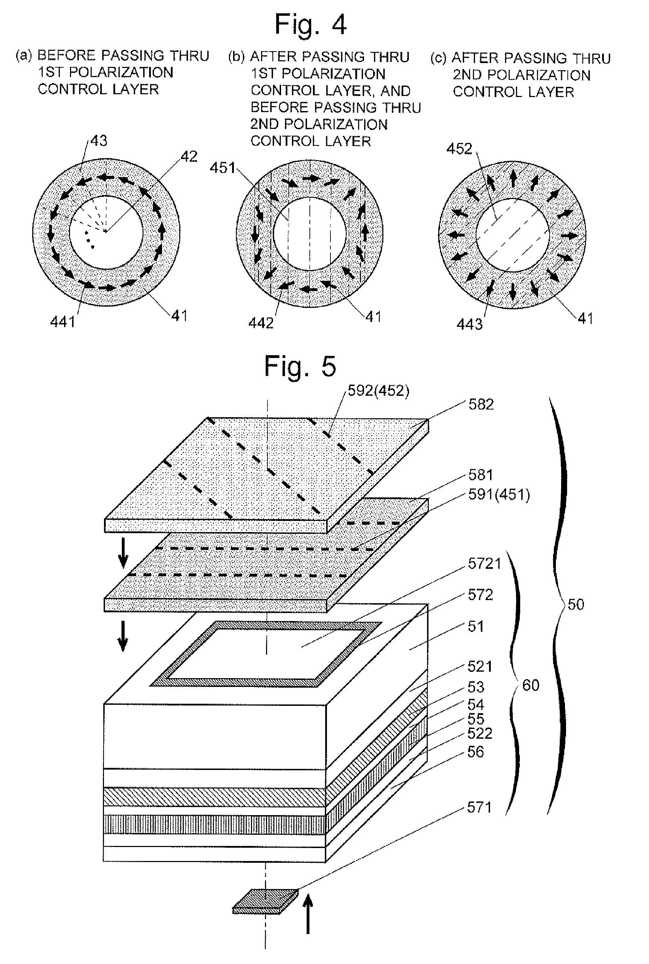

The state of the laser beam changes as illustrated in Fig. 4, which shows the cross-sectional shape and polarizing direction of the laser beam at the following points in time: (a) after the laser beam has been emitted from the two-dimensional photonic crystal and before it passes through the first polarization control element, (b) after the beam has passed through the first polarization control element and before it passes through the second polarization control element, and (c) after the beam has passed through the second polarization control element. In Fig. 4, the gray section 41 indicates the area where the light is passing.
As already explained, when fresh from emission from the two-dimensional photonic crystal, the laser beam has an annular cross section in which the light has no strength at around the center and has finite strengths at positions apart from the center. This cross-sectional shape remains intact even after the laser beam has passed through the first and second polarization control elements.
When fresh from emission from the two-dimensional photonic crystal, the laser beam is polarized in the circumferential direction 441 at any point within its cross section (Fig. 4(a)). After the laser beam has passed through the first polarization control element, the polarizing direction at each point changes to an axially symmetrical direction 442 with respect to the fast axis 451 of the first polarization control element (Fig. 4(b)). Subsequently, the laser beam passes through the second polarization control element, after which the polarizing direction at each point changes to an axially symmetrical direction 443 with respect to the fast axis 452 of the second polarization control element (i.e. an axis extending at an angle of 45° to the fast axis 451) (Fig. 4(c)). The resultant laser beam is polarized in the radial direction 443 at any point within its cross section.
Thus, the surface emitting laser according to the present invention can generate a radially polarized annular laser beam (Fig. 4(c)).

The radially polarized annular laser beam generated by the surface emitting laser according to the present invention can be converged by a focusing lens to a diameter smaller than the diffraction limit, as described in Non-Patent Document 1.

### EMBODIMENT

An embodiment of the surface emitting laser according to the present invention is hereinafter described with reference to Figs. 5 to 9.

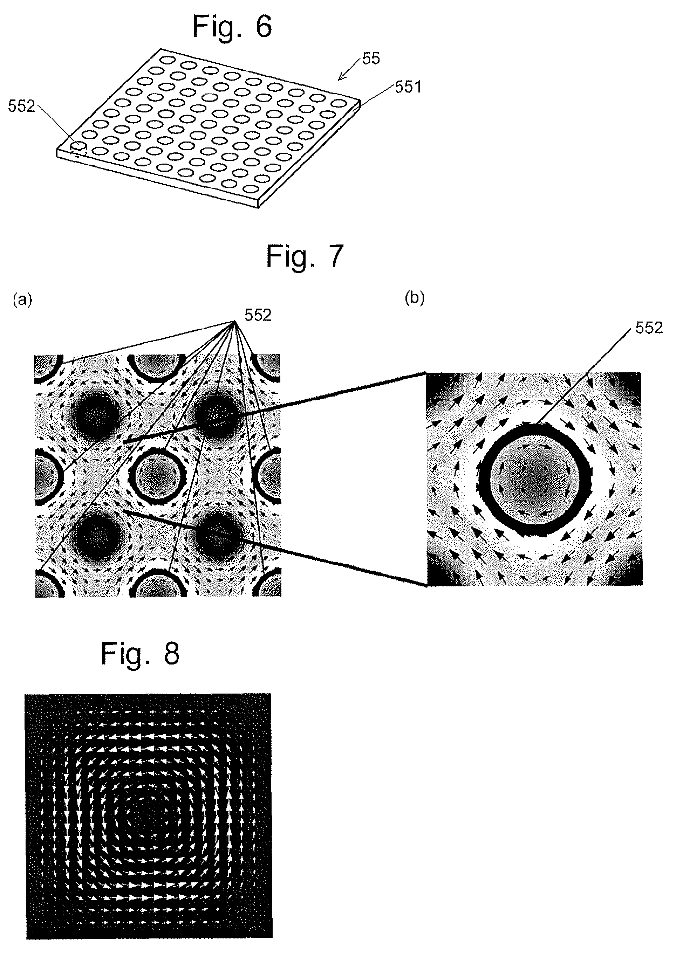

Fig. 5 is a perspective view of the surface emitting laser 50 in the present embodiment. This laser includes a substrate 51 made of an n-type semiconductor of gallium arsenide (GaAs), under which an active layer 53 made of indium gallium arsenide (InGaAs)/galliun arsenide (GaAs) and having multiple-quantum wells (MQW) is located, with a cladding layer 521 made of an n-type semiconductor of aluminum gallium arsenide (AIGaAs) in between. Under the active layer 53, a two-dimensional photonic crystal layer 55 is located, with a carrier-blocking layer 54 made of AlGaAs in between. The two-dimensional photonic crystal in the preset embodiment is a plate-shaped p-GaAs body material 551 in which circular holes 552 are periodically arranged in a square lattice pattern (Fig. 6). Beneath this two-dimensional photonic crystal 55, a cladding layer 522 made of p-AlGaAs and a contact layer 56 made of p-GaAs are located, and a lower electrode 571 is provided at the center of the back face of the contact layer 56. An upper electrode 572 with a central window 5721 is provided on the upper face of the substrate 51. The components listed thus far constitute a laser oscillator 60 (exclusive of the first polarization control layer 583 and the second polarization control layer 582, which is subsequently described).

The first polarization control layer 581 and the second polarization control layer 582 are layered on the upper face of the substrate 51. The two polarization control layers 581 and 582 each function as a half-wave plate and are oriented so that the fast axis 591 of the first polarization control layer 581 makes an angle of 45° with the fast axis 592 of the second polarization control layer 582. Such polarization control layers can be made from crystal, mica, or polymers normally used for creating half-wave plates. It is also possible to use a Fresnel rhombohedron made of glass.

The substrate 51, the first polarization control layer 581 and the second polarization control layer 582 shown in Fig. 5 are separated from each other for the convenience of explanation, but actually they are adhered to each other in the present embodiment. However, it is also possible to provide the first polarization control layer 581 and the second polarization control layer 582 separately from the substrate 51 or other elements.

An operation of the surface emitting laser in the present embodiment is hereinafter described. When a voltage is applied between the lower electrode 571 and upper electrode 572 to generate a current between the two electrodes, the electrons and positive holes injected into the device recombine together within the active layer 53 and emit light. Among various components of light generated within the active layer 53, the light having a specific wavelength is strengthened by interference within the two-dimensional photonic crystal 55. Thus, a laser oscillation results.

The laser beam thus generated is emitted from the substrate 51 and enters the first polarization control layer 581 through the window 5721. At this stage, the laser beam has an annular cross section in which the beam strength is zero at the central area and has finite values around this area. The polarization of the laser beam is in the circumferential direction.

The laser beam that has entered the first polarization control layer 581 has its polarizing direction changed to an axially symmetrical direction with respect to the fast axis 591 (451), as shown in Fig. 4(b), and then exits the first polarization control layer 581. Subsequently, the laser beam enters the second polarization control layer 582, where the polarizing direction is changed to an axially symmetrical direction with respect to the fast axis 592 (452), as shown in Fig. 4(c). Meanwhile, the cross-sectional shape of the laser beam remains intact even after the beam has passed through the first polarization control layer 581 and the second polarization control layer 582. Thus, a radially polarized laser beam with an annular cross section is obtained from the upper face of the second polarization control layer 582.

Figs. 7(a) and 7(b) show the result of a calculation (by the plane wave expansion method) of the electromagnetic field distribution within the two-dimensional photonic crystal 55 in the surface emitting laser of the present embodiment. Specifically, Fig. 7(a) shows an area with nine holes 552 arrayed in a 3x3 pattern, and Fig. 7(b) shows an enlarged view of a portion of this area. The gray shading represents the magnetic field distribution. The length and direction of each arrow respectively indicate the magnitude and direction of the electric field. These figures show that an electric field surrounding the hole 552 is created.
Fig. 8 shows the result of a finite time domain difference (FDTD) calculation of the strength and polarizing direction at a cross section of the laser beam emitted from the surface of the substrate 51. The length of each arrow indicates the strength of laser light, and the direction of each arrow indicates the polarizing direction. Similar to the previously explained result shown in Fig. 4(a), the result in Fig. 8 illustrates that a circumferentially polarized laser beam with an annular cross section in which the beam has no strength at the central area and finite strengths at around this area is emitted from the surface of the substrate 51. It seems that this polarizing direction results from the aforementioned creation of an electric field surrounding each hole 552 within the two-dimensional photonic crystal 55.

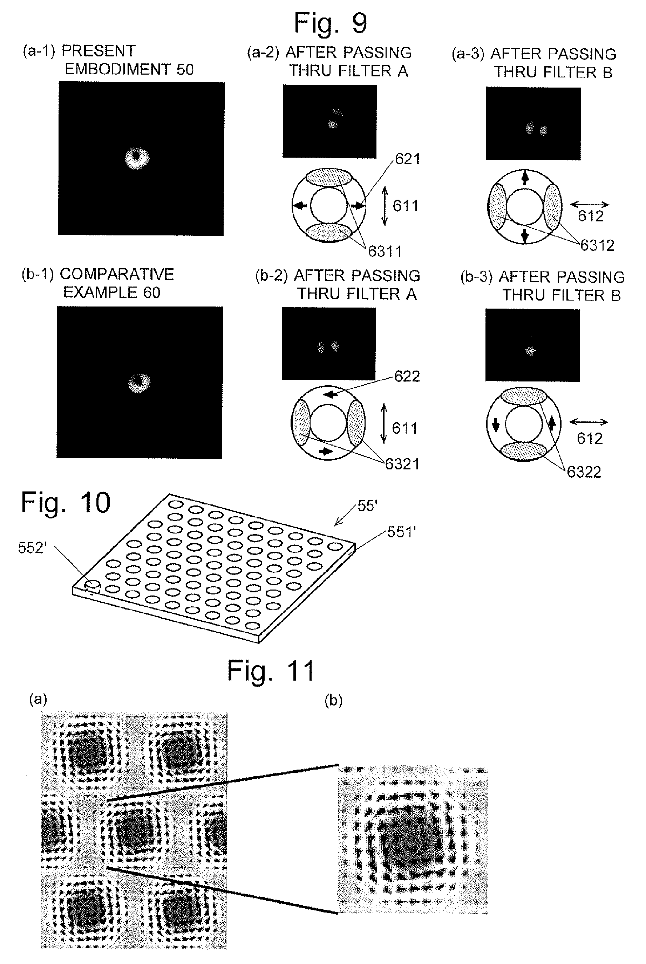

A photograph of a cross section of the laser beam generated by the surface emitting laser 50 in the present embodiment was taken, as labeled (a-1) in Fig. 9. As a comparative example, a cross section of the laser beam generated by another surface emitting laser consisting only of the laser oscillator 60 (without the first polarization control layer 581 and the second polarization control layer 582) was also photographed, as labeled (b-1) in Fig. 9. These photographs (a-1) and (b-1) demonstrate that a laser beam with an annular cross section was obtained in both the present embodiment and comparative example.

To determine the polarizing direction of the laser beams shown in (a-1) and (b-1), these laser beams were passed through a polarization filter A, through which only the vertically polarized component of light (labeled 611) in Fig. 9 could pass, and the cross sections of the resultant laser beams were photographed, as labeled (a-2) and (b-2) in Fig. 9. The same laser beams were also passed through another polarization filter B, through which only the horizontally polarized component of light (labeled 612) in Fig. 9 could pass, and the cross sections of the resultant laser beams were photographed, as labeled (a-3) and (b-3) in Fig. 9. The photographs (a-2) and (a-3) prove that the passage of light occurred only at the portion 6311 or 6312 where the polarizing direction 611 or 612 of the light component that could pass through the polarization filter matched the direction 621 of radial polarization. This result confirms that the laser beam obtained in the present embodiment was radially polarized. In the comparative example, the passage of light occurred only at the portion 6321 or 6322 where the circumferentially polarized light 622 could pass through the polarization filter, as shown in (b-2) and (b-3) in Fig. 9.

The device in the previous embodiment used the two-dimensional photonic crystal 55 consisting of the body material 551 with the holes 552 arranged in a square lattice pattern. However, this is not the only form of the two-dimensional photonic crystal usable in the present invention. For example, the two-dimensional photonic crystal 55' shown in Fig. 10, which consists of a body material 551' with holes 552' arranged in a triangular lattice pattern, is also usable. The result of a calculation of the electromagnetic field distribution within this two-dimensional photonic crystal 55' by the plane wave expansion method is shown in Figs. 11(a) and 11(b), where (b) is an enlarged view of a portion of (a). The dark gray areas represent the portions where a strong magnetic field is present. These portions coincide with the holes. The electric field, which is represented by the arrows in Figs. 11(a) and 11(b), surrounds each hole, similar to the case shown in Fig. 7. Thus, as in the previous case where the two-dimensional photonic crystal 55 was used, the laser beam generated by the present two-dimensional photonic crystal 55' and emitted from the surface of the substrate 51 is also polarized in the circumferential direction, and passing this laser beam through the first polarization control layer 581 and the second polarization control layer 582 results in a radially polarized laser beam.

## Claims

1. A two-dimensional photonic crystal surface emitting laser, comprising:
a) a laser oscillator including an active layer, a two-dimensional photonic crystal located on one side of the active layer, and a pair of electrodes between which the active layer and the two-dimensional photonic crystal are sandwiched, the laser oscillator emitting a circumferentially polarized laser beam with an annular cross section from the two-dimensional photonic crystal when a voltage is applied between the electrodes;
b) a first polarization control element, which is located on an optical path of the laser beam generated by the laser oscillator and functions as a half-wave plate; and
c) a second polarization control element, which is located on the optical path of the laser beam and functions as a half-wave plate, with a fast axis extending at an angle of 45° to that of the first polarization control element.

2. The two-dimensional photonic crystal surface emitting laser according to claim 1, wherein the two-dimensional photonic crystal has a structure having a rotational symmetry with respect to an axis perpendicular to a surface of the crystal.

3. The two-dimensional photonic crystal surface emitting laser according to claim 2, wherein the two-dimensional photonic crystal has circular modified refractive index areas arranged in a square or triangular lattice pattern.

4. The two-dimensional photonic crystal surface emitting laser according to claim 1, wherein the first polarization control element and the second polarization control element are layered on the laser oscillator.

5. A super-resolution laser beam generator, comprising:
the two-dimensional photonic crystal surface emitting laser according to one of claims 1 to 4; and
a focusing lens for converging a laser beam generated by the two-dimensional photonic crystal surface emitting laser to a diameter equal to or smaller than a diffraction limit.

6. An optical pickup, wherein the super-resolution laser beam generator according to claim 5 is provided as a light source.

7. A laser-processing apparatus, wherein the two-dimensional photonic crystal surface emitting laser light source according to one of claims 1 to 4 is provided as a light source for irradiating a workpiece with light.
